# FASCICULE DE BREVET EUROPEEN

(11) **EP 2 973 750 B1**
(45) Date de publication et mention de la délivrance du brevet: **01.03.2017**
(21) Numéro de dépôt: 14715369.6
(22) Date de dépôt: 14.03.2014
(51) Int. Cl.: H01L 33/00

(54) **PROCEDE DE FORMATION DE DIODES ELECTROLUMINESCENTES**
VERFAHREN ZUR HERSTELLUNG VON LEUCHTDIODEN
PROCESS FOR FORMING LIGHT-EMITTING DIODES

(30) Priorité: 14.03.2013 FR 1352275
(43) Date de publication de la demande: 20.01.2016
(73) Titulaire: Commissariat à l'Energie Atomique et aux Energies Alternatives, 75015 Paris (FR)
(72) Inventeur: BONO, Hubert, F-38000 Grenoble (FR); ANDRE, Bernard, F-38950 Quaix en Chartreuse (FR); GASSE, Adrien, F-38180 Seyssins (FR)
(74) Mandataire: Thibon, Laurent
(86) Numéro de dépôt international: PCT/FR2014/050602
(87) Numéro de publication internationale: WO 2014/140505

(56) Documents cités:
- WO-A1-2009/121314
- WO-A1-2012/075461
- US-A1- 2006 214 178

## Description

La présente demande de brevet revendique la priorité de la demande de brevet français FR13/52275 .

### Domaine

La présente demande concerne la fabrication de diodes électroluminescentes et plus particulièrement un procédé d'encapsulation de diodes électroluminescentes.

### Exposé de l'art antérieur

De façon générale, les diodes électroluminescentes sont fabriquées sur des substrats puis découpées en puces individuelles avant d'être montées sur des supports.

Le document US 2006/0214178 décrit un procédé de fabrication, d'encapsulation et de montage de diodes électroluminescentes.

Les divers procédés connus de fabrication, d'encapsulation et de montage de diodes électroluminescentes impliquent la mise en oeuvre de très nombreuses étapes dont certaines sont complexes impliquant notamment des reports de puces et la prévision de poignées multiples.

### Résumé

On vise ici à proposer un procédé collectif de fabrication et d'encapsulation de diodes électroluminescentes qui soit particulièrement simple à mettre en oeuvre et qui assure que le montage des diodes électroluminescentes puisse se faire dans des conditions optimales de dissipation thermique.

Ainsi, un mode de réalisation prévoit un procédé de fabrication de diodes électroluminescentes comprenant les étapes suivantes :
a) former des diodes électroluminescentes sur une couche de silicium d'une plaquette de type SOI, ladite couche reposant sur un support ;
b) coller du côté des diodes électroluminescentes une plaquette de silicium formant capot munie d'un évidement non traversant en regard de chaque diode électroluminescente ;
c) araser la plaquette de silicium pour former une ouverture traversante en regard de chaque diode électroluminescente ;
d) remplir chaque ouverture d'un matériau transparent ; et
e) éliminer au moins partiellement le support de la plaquette de type SOI sur la totalité de la plaquette de type SOI et réaliser des métallisations de connexion et de drain thermique.

Selon un mode de réalisation, au moins l'élimination du support de la plaquette de type SOI de l'étape e) est réalisée avant les étapes c) et d).

Selon un mode de réalisation, les étapes c), d) et e) sont successives.

Selon un mode de réalisation, le procédé comprend en outre une étape de découpe en diodes électroluminescentes individuelles ou en groupes de diodes électroluminescentes.

Selon un mode de réalisation, les faces latérales de chaque évidement de la plaquette de silicium formant capot sont revêtues d'un dépôt réflecteur.

Selon un mode de réalisation, les diodes électroluminescentes sont des diodes électroluminescentes à nanofils.

Selon un mode de réalisation, les nanofils sont des nanofils de GaN.

Selon un mode de réalisation, les nanofils sont formés à partir d'une couche de germination déposée sur la couche de silicium.

Selon un mode de réalisation, le remplissage des ouvertures est réalisé par un matériau transparent muni de luminophores dans sa partie voisine des diodes électroluminescentes.

Selon un mode de réalisation, la face externe du matériau de remplissage est conformée pour avoir des caractéristiques optiques souhaitées.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue en perspective éclatée d'une étape intermédiaire d'un procédé collectif de formation de diodes électroluminescentes, et
les figures 2 à 8 sont des vues en coupe schématiques illustrant des étapes successives d'un mode de réalisation d'un procédé collectif de fabrication de diodes électroluminescentes.

Par souci de clarté, de mêmes éléments ont été désignés par de mêmes références aux différentes figures et, de plus, comme cela est habituel dans la représentation des circuits intégrés, les diverses figures ne sont pas tracées à l'échelle.

### Description détaillée

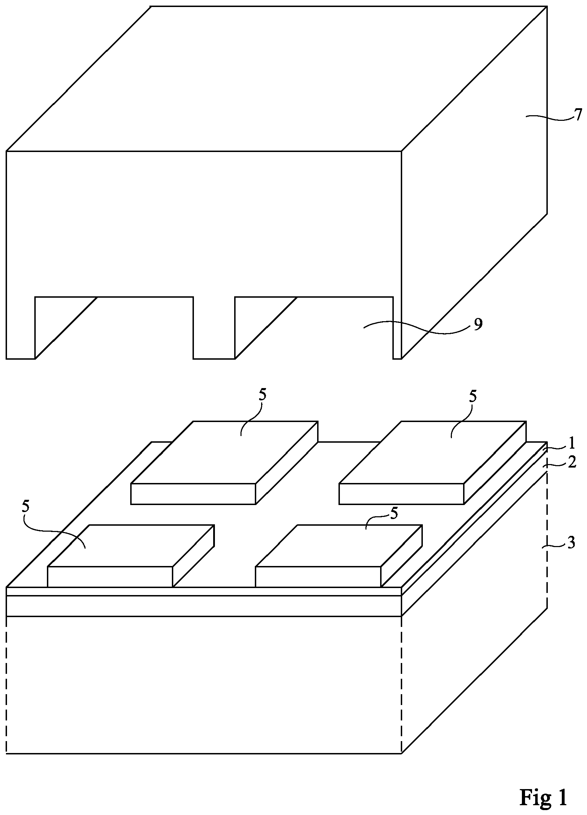

La figure 1 est une vue en perspective éclatée d'une étape intermédiaire d'un procédé collectif de formation et d'encapsulation de diodes électroluminescentes tel que proposé ici. Les diodes électroluminescentes sont fabriquées sur une plaquette de type SOI comprenant une couche mince de silicium 1, pouvant être électriquement conductrice, disposée sur un support de nature physique ou chimique différente. Dans le cas le plus courant, actuellement, le support comprend une couche isolante 2, couramment une couche d'oxyde de silicium, elle-même formée sur une poignée 3, correspondant par exemple à une plaque de silicium. La couche de silicium 1 repose sur la couche isolante 2.

On notera toutefois que ce que l'on désigne ici par "plaquette de type SOI" vise de façon générale une couche mince de silicium, couramment d'une épaisseur pouvant aller de 10 nm à 10 µm reposant sur un support de nature différente, de préférence un support isolant. Le support peut être monobloc et jouer directement le rôle de poignée ou correspondre à une structure multicouche comprenant une couche isolante reposant sur une poignée éventuellement non isolante.

Sur la couche mince de silicium 1, on a représenté schématiquement quatre diodes électroluminescentes 5 susceptibles d'émettre de la lumière vers le haut. La référence 7 désigne un capot, de préférence constitué d'une plaquette de silicium, ce capot étant muni d'évidements 9. Ce capot est destiné à être assemblé sur la plaquette de type SOI de façon que chaque diode électroluminescente 5 se trouve en regard d'un évidement 9.

On notera qu'un avantage d'utiliser une plaquette SOI à base de silicium et un capot à base de silicium est que l'on évite ainsi les problèmes de dilatation thermique différentielle entre ces deux éléments.

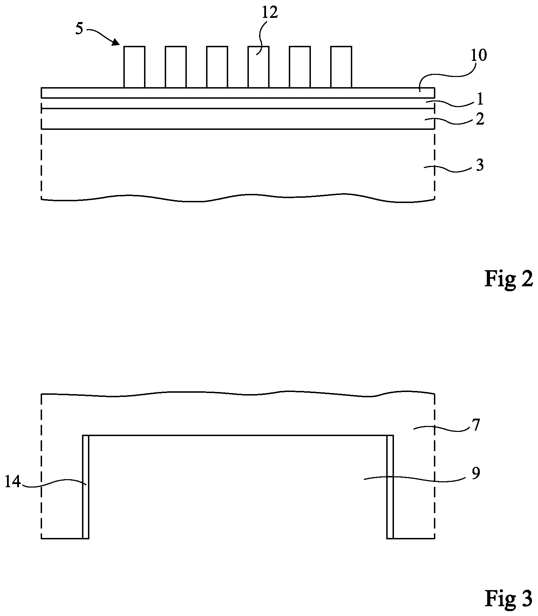

La figure 1 était destinée à bien faire comprendre que le procédé décrit ici est un procédé collectif. Un mode de réalisation particulier du procédé proposé ici va maintenant être décrit plus en détail en relation avec les vues en coupe des figures 2 à 8 qui illustrent des étapes successives de mise en oeuvre d'un mode de réalisation du procédé. Chacune des vues en coupe est une vue partielle illustrant la formation d'une seule diode électroluminescente. On prendra ici l'exemple de diodes électroluminescentes formées à partir de nanofils, par exemple des nanofils de GaN. Néanmoins, tout type de diode électroluminescente pourra être utilisé.

Dans la vue en coupe de la figure 2, on retrouve la plaquette de type SOI comprenant la couche mince de silicium 1, la couche d'oxyde de silicium 2 et la poignée de silicium 3. Sur la couche mince 1 de silicium, on a déposé une couche de germination 10, par exemple une couche d'AlN, ou de tout autre matériau adapté, dans le cas où on veut faire croître des nanofils de GaN. Après quoi, un masquage (non représenté) a été effectué, ou tout autre procédé adapté a été mis en oeuvre, de façon à faire croître des nanofils de GaN 12 dans des zones choisies, couramment selon un motif en damier.

De façon classique, chaque nanofil 12 peut être recouvert d'une couche active comprenant, par exemple, une structure à puits quantiques multiples, et les couches actives peuvent être recouvertes d'une électrode transparente. Sur les figures 2 à 7, les couches actives et les électrodes des diodes électroluminescentes 5 ne sont pas représentées.

La figure 3 représente une portion d'un capot 7 formé dans une plaquette de silicium de même diamètre que la plaquette de type SOI. Ce capot comprend des évidements 9 dont chacun est destiné à venir coiffer une diode électroluminescente 5. De préférence, les faces latérales des évidements 9 sont revêtues d'une couche réfléchissante 14, par exemple une couche d'aluminium. Pour former cette couche d'aluminium sur les parois des évidements, on pourra procéder à un dépôt pleine plaque d'aluminium suivi d'une gravure plasma anisotrope qui laisse en place l'aluminium sur les faces latérales. Les évidements 9 sont non traversants.

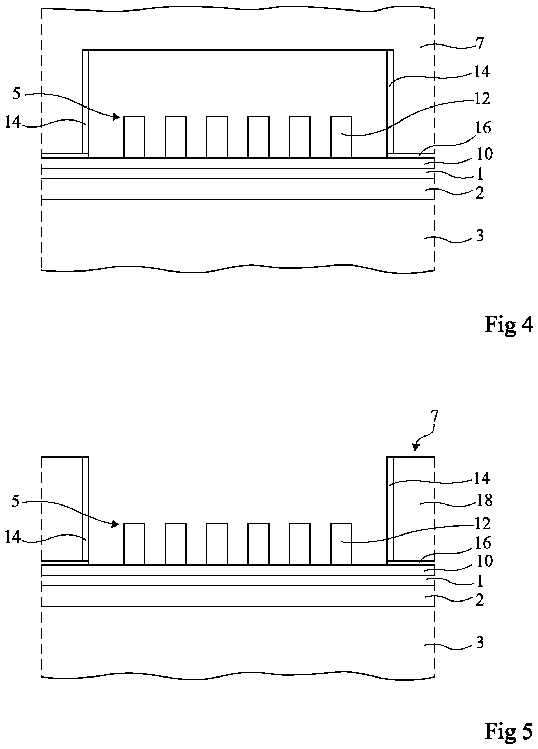

A l'étape suivante, illustrée en figure 4, le capot 7 est mis en place. Il est collé sur la couche supérieure de la plaquette de SOI par tout moyen, par exemple par brasage, en utilisant une couche de colle 16, ou bien encore par collage moléculaire ou collage optique. Dans ce dernier cas, on pourra prévoir de former au préalable de minces couches d'oxyde de silicium sur les faces devant venir en contact.

La figure 5 illustre une étape suivante, dans laquelle on arase à ce stade la partie supérieure du capot 7 de façon que les diodes électroluminescentes soient découvertes et qu'il reste des parois (un maillage) 18 du capot 7 entre les diodes électroluminescentes.

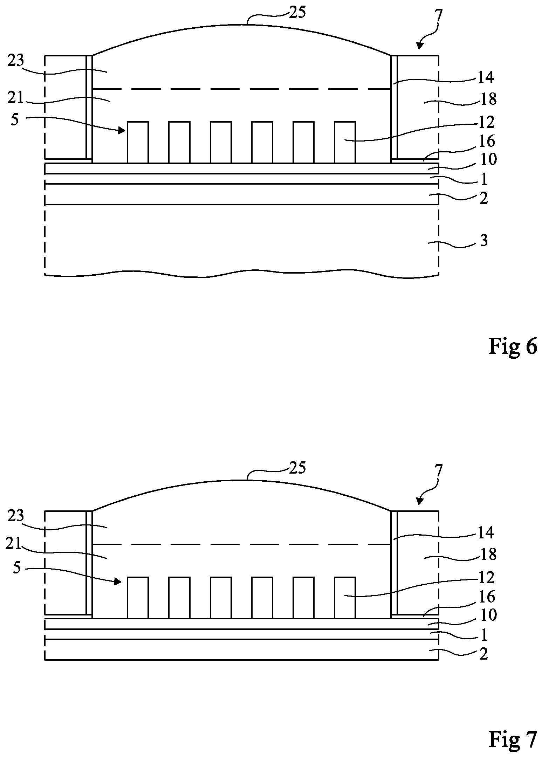

A l'étape illustrée en figure 6, on a rempli les ouvertures formées dans le capot arasé d'un produit propre à protéger les diodes électroluminescentes et à assurer leur bon fonctionnement. Par exemple, on pourra réaliser un premier remplissage par une matière transparente 21 contenant un luminophore puis un deuxième remplissage par une matière transparente 23. La matière transparente est par exemple du silicone. Les couches 21 et 23 peuvent ne faire qu'une et être constituées d'un encapsulant contenant des luminophores. La face supérieure 25 est conformée de façon souhaitée, par exemple en lentille. On pourra également prévoir que cette face supérieure est plane ou encore est conformée en lentille de Fresnel.

Ensuite, à l'étape illustrée en figure 7, on a éliminé la poignée 3 de la plaquette de SOI. Alors, la couche inférieure en figure 7 est la couche d'oxyde de silicium 2, dans l'exemple décrit ici. Après cette étape, la tenue mécanique de la plaquette restante est assurée par le maillage 18 des parties restantes du capot 7. Le retrait de la poignée 3 peut être réalisé par tout type de gravure, la couche d'oxyde de silicium 2 pouvant jouer le rôle de couche d'arrêt de gravure. Le retrait de la poignée 3 est, de préférence, réalisé sur la totalité de la plaquette de SOI.

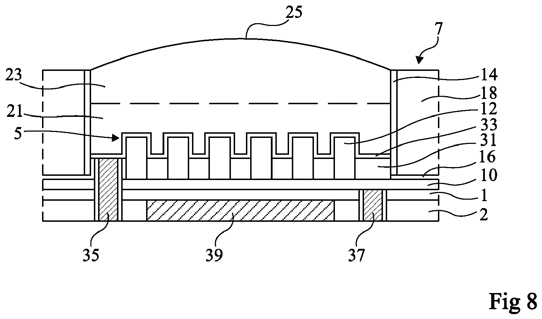

En figure 8, on a représenté un peu plus en détail la structure de diodes électroluminescentes à nanofils. On a représenté que le bas des nanofils est entouré d'une couche isolante 31 et que l'ensemble de la structure à nanofils est recouvert d'une couche conductrice transparente 33. Bien entendu, les couches 31 et 33 auront été formées dès la fabrication des nanofils illustrée en figure 2, avant mise en place du capot 7. Un premier via ou plutôt un ensemble de premiers vias 35 vient en contact avec la couche conductrice transparente 33 à travers les couches 2, 1, 10 et 31. Un deuxième via ou plutôt un ensemble de deuxièmes vias 37 vient en contact avec la couche conductrice 10 sur laquelle reposent les nanofils. On assure ainsi la connexion des diodes électroluminescentes. On notera que le via 35 doit être un via isolé. On a également représenté le via 37 comme un via isolé car il est plus simple de le fabriquer de façon similaire au via 35. Toutefois, le via 37 n'est pas nécessairement isolé puisqu'il peut sans inconvénient être en contact avec la couche mince de silicium 1 qui peut être électriquement conductrice. Enfin, un évidement a été formé dans la couche d'oxyde de silicium 2 sous la diode électroluminescente. Cet évidement est rempli partiellement ou complètement d'une couche métallique 39 servant de drain thermique, destinée à être mise en contact avec un radiateur lors du montage des diodes électroluminescentes après leur découpe en éléments individuels, ou en groupes d'éléments.

On notera qu'à partir de la figure 5, on a décrit une première variante dans laquelle on commence par éliminer une partie supérieure du capot pour découvrir les diodes électroluminescentes. Selon une deuxième variante, on commence par les étapes d'élimination de la poignée 3 de la plaquette SOI. On choisira l'une ou l'autre des deux variantes selon les commodités pratiques et selon les épaisseurs des divers supports pour assurer qu'il reste toujours en place suffisamment de matière pour assurer la tenue mécanique et la maniabilité de l'ensemble.

On notera que le procédé décrit ci-dessus présente de nombreux avantages :
1. Le procédé résout les problèmes thermiques associés aux diodes électroluminescentes en ce que le fond de chaque diode électroluminescente (le côté non-émetteur) repose sur une couche mince de silicium provenant d'une plaquette de type SOI et a donc une épaisseur très faible. Cette couche mince de silicium est revêtue d'un drain thermique favorisant la dissipation thermique. En outre, ce procédé fournit des diodes électroluminescentes à caractéristiques thermiques bien reproductibles, l'épaisseur de la couche mince de silicium d'une plaquette de type SOI étant constante et reproductible.
2. Le procédé est mis en oeuvre en utilisant seulement deux plaquettes et pas de poignée intermédiaire. Il est alors particulièrement simple à mettre en oeuvre, les manipulations étant toujours aisées.
3. Toute la fabrication résulte d'un procédé collectif. C'est seulement à la fin, une fois que les diodes électroluminescentes ont été formées et encapsulées et que les contacts et les drains thermiques ont été mis en place, que la structure est découpée en diodes électroluminescentes individuelles (ou en petits groupes de diodes électroluminescentes).
4. Le fait que les évidements 9 sont non traversants permet, de façon avantageuse, de conserver au capot 7 une rigidité mécanique suffisante lors de sa manipulation et de son collage. Les étapes de manipulation du capot 7 sont ainsi simplifiées. En particulier, la rigidité du capot est augmentée par rapport à un capot comprenant des ouvertures avant la fixation du capot à la plaquette de SOI, notamment comme cela est le cas pour le dispositif décrit dans le document US 2006/0214178.
5. La plus grande rigidité du capot 7 permet d'augmenter les dimensions latérales des évidements 9, dans un plan parallèle à la couche mince 1, par rapport aux dimensions latérales du capot 7, et notamment de prévoir un capot 7 pour lequel le rapport entre la surface des ouvertures, dans un plan parallèle à la couche mince 1, et la surface du capot est supérieur ou égal à 0,6, de préférence à 0,7, plus préférentiellement à 0,8. Ceci permet avantageusement d'augmenter la surface de la plaquette de type SOI utilisée pour la formation de diodes électroluminescentes par rapport à un dispositif dans lequel le capot, avant collage sur la plaquette de SOI, est muni d'ouvertures traversantes et pour lequel, pour maintenir une tenue mécanique suffisante, le rapport entre la surface des ouvertures, dans un plan parallèle à la face supérieure de la plaquette de SOI, et la surface du capot est inférieur à 0,3, comme cela est le cas pour le dispositif décrit dans le document US 2006/0214178.
6. Le fait que la poignée 3 est retirée sur la totalité de la plaquette de SOI, et non, par exemple, seulement au niveau des diodes électroluminescentes, comme cela est par exemple le cas pour la structure décrite dans le document US 2006/0214178, permet d'éviter l'apparition de contraintes en raison de la différence des coefficients de dilatation entre le matériau constituant la poignée et les matériaux d'éléments déposés ultérieurement sur la poignée.

L'homme de l'art saura choisir les natures et épaisseurs des divers éléments décrits ici pour qu'ils satisfassent aux fonctions décrites. Uniquement à titre d'exemple, on pourra procéder aux choix suivants.
Couche mince de silicium 1 : épaisseur comprise entre 100 nm et 10 µm.
Couche isolante 2 : couche ou multicouche diélectrique, de préférence bon conducteur thermique. On peut citer de manière non exhaustive : l'oxyde de silicium, le nitrure de silicium, le carbure de silicium, le nitrure d'aluminium ou le nitrure de bore, etc... Cette couche 2 peut avoir une épaisseur comprise entre 50 nm et 10 µm.
Plaque de silicium 3 : épaisseur comprise entre 300 et 800 µm, selon son diamètre.
Capot 7 : épaisseur comprise entre 300 et 800 µm, selon son diamètre.
Évidements 9 : profondeur comprise entre 200 et 600 µm (suffisante pour que la hauteur des parois 18 restantes après arasement du capot 7 assure la tenue mécanique après élimination de la poignée 3).
Couche de germination 10 : par exemple une couche d'AlN, ou de tout autre métal ou composé adapté, d'une épaisseur comprise entre 50 et 500 nm.
Nanofils 12 : nanofils de GaN d'une hauteur comprise entre 1 et 500 µm, couramment entre 5 et 20 µm.
Dimensions latérales des diodes électroluminescentes : de 0,1 à 5 mm. De plus, ces diodes pourront être interconnectées soit en parallèle pour assurer la redondance, soit en série pour ajuster la tension de fonctionnement.

## Revendications

1. Procédé de fabrication de diodes électroluminescentes comprenant les étapes suivantes :
a) former des diodes électroluminescentes (5) sur une couche de silicium (1) d'une plaquette de type SOI (1, 2, 3), ladite couche reposant sur un support (2, 3) ;
b) coller du côté des diodes électroluminescentes une plaquette de silicium formant capot (7) munie d'un évidement (9) non traversant en regard de chaque diode électroluminescente ;
c) araser la plaquette de silicium collée pour former une ouverture traversante en regard de chaque diode électroluminescente ;
d) remplir chaque ouverture d'un matériau transparent (21, 23) ; et
e) éliminer au moins partiellement le support (3) de la plaquette de type SOI sur la totalité de la plaquette de type SOI et réaliser des métallisations de connexion et de drain thermique.

2. Procédé selon la revendication 1, dans lequel les étapes c), d) et e) sont successives.

3. Procédé selon la revendication 1, dans lequel au moins l'élimination du support de la plaquette de type SOI de l'étape e) est réalisée avant les étapes c) et d).

4. Procédé selon l'une quelconque des revendications 1 à 3, comprenant en outre une étape de découpe en diodes électroluminescentes individuelles ou en groupes de diodes électroluminescentes.

5. Procédé selon l'une quelconque des revendications 1 à 4, dans lequel les faces latérales de chaque évidement (9) de la plaquette de silicium formant capot sont revêtues d'un dépôt réflecteur (14).

6. Procédé selon l'une quelconque des revendications 1 à 5, dans lequel les diodes électroluminescentes sont des diodes électroluminescentes à nanofils (12).

7. Procédé selon la revendication 6, dans lequel les nanofils sont des nanofils de GaN.

8. Procédé selon la revendication 7, dans lequel les nanofils sont formés à partir d'une couche de germination (10) déposée sur la couche de silicium (1).

9. Procédé selon l'une quelconque des revendications 1 à 8, dans lequel le remplissage des ouvertures est réalisé par un matériau transparent (21, 23) muni de luminophores dans sa partie voisine des diodes électroluminescentes.

10. Procédé selon l'une quelconque des revendications 1 à 9, dans lequel la face externe du matériau de remplissage est conformée pour avoir des caractéristiques optiques souhaitées.

11. Procédé selon l'une quelconque des revendications 1 à 10, dans lequel le support (2, 3) de la plaquette de type SOI comprend une poignée (3) et une couche isolante (2) interposée entre la poignée et la couche de silicium (1) et dans lequel, à l'étape (e), la poignée est retirée en totalité.

## Patentansprüche

1. Ein Verfahren zum Herstellen Licht emittierende Dioden, das die folgenden Schritte aufweist:
a) Ausbilden bzw. Formen von lichtemittierenden Diode (5) auf einer Siliziumschicht (1) auf einem SOI-Wafer (1, 2, 3), wobei die Schicht auf einem Träger (2, 3) aufliegt;
b) Blonden bzw. Verkleben, auf der Seite der lichtemittierenden Dioden, eines Silizium-Wafers, der eine Abdeckung (7) bildet, die mit einer nicht durchgängigen Vertiefung bzw. Ausnehmung (9) gegenüber jeder lichtemittierenden Diode versehen ist;
c) Abschleifen bzw. Abnehmen des gebondeten Silizium-Wafers, um eine Durchgangsöffnung gegenüber jeder lichtemittierenden Diode zu bilden;
d) Füllen jeder Öffnung mit einem transparenten Material (21, 23); und
e) wenigstens teilweises Entfernen des Trägers (3) des SOI-Wafers von dem gesamten SOI-Wafer und Ausbilden von Verbindungs- und Wärmesenkenmetall isierungen.

2. Verfahren nach Anspruch 1, wobei die Schritte c), d), und e), aufeinander folgen.

3. Verfahren nach Anspruch 1, wobei wenigstens die Entfernung des Trägers des SOI-Wafers aus Schritt e) vor den Schritten c) und d) ausgeführt wird.

4. Verfahren nach einem der Ansprüche 1 bis 3, das weiter einen Schritt des Schneidens in eine individuelle lichtemittierende Diode oder in Gruppen von lichtemittierenden Dioden aufweist.

5. Verfahren nach einem der Ansprüche 1 bis 4, wobei die Seitenflächen jeder Ausnehmung (9) des Silizium-Wafers, der eine Abdeckung bildet, mit einer reflektierenden Ablagerung (14) beschichtet sind.

6. Verfahren nach einem der Ansprüche 1 bis 5, wobei die lichtemittierenden Dioden lichtemittierende Nanodraht-Dioden (12) sind.

7. Verfahren nach Anspruch 6, wobei die Nanodrähte GaN-Nanodrähte sind.

8. Verfahren nach Anspruch 7, wobei die Nanodrähte aus einer Saat- bzw. Keimschicht (10) gebildet werden, die auf der Siliziumschicht (1) abgeschieden wird.

9. Verfahren nach einem der Ansprüche 1 bis 8, wobei das Auffüllen der Öffnungen mit einem transparenten Material (21, 23) durchgeführt wird, das in seinem Teil nahe der Licht emittierenden Dioden mit Leuchtstoffen versehen ist.

10. Verfahren nach einem der Ansprüche 1 bis 9, wobei die Außenfläche des Füllmaterials so geformt wird, dass sie die erwünschten optischen Charakteristiken hat.

11. Verfahren nach einem der Ansprüche 1 bis 10, wobei der Träger (2, 3) des SOI-Wafers einen Griff (3) und eine Isolierschicht (2) hat, die zwischen dem Griff und der Siliziumschicht (1) zwischengelagert ist, und wobei bei Schritt (e) der Griff vollständig entfernt wird.

## Claims

1. A light-emitting diode manufacturing method comprising the steps of:
a) forming light-emitting diodes (5) on a silicon layer (1) of an SOI-type wafer (1, 2, 3), said layer resting on a support (2, 3) ;
b) bonding on the light-emitting diode side a silicon wafer forming a cap (7) provided with a non-through recess (9) opposite each light-emitting diode;
c) leveling down the bonded silicon wafer to form a through opening opposite each light-emitting diode;
d) filling each opening with a transparent material (21, 23); and
e) at least partially removing the support (3) of the SOI-type wafer from the entire SOI-type wafer and forming connection and heat sink metallizations.

2. The method of claim 1, wherein steps c), d), and e) follow one another.

3. The method of claim 1, wherein at least the removal of the support of the SOI-type wafer of step e) is carried out before steps c) and d).

4. The method of any of claims 1 to 3, further comprising a step of cutting into individual light-emitting diodes or into groups of light-emitting diodes.

5. The method of any of claims 1 to 4, wherein the lateral surfaces of each recess (9) of the silicon wafer forming a cap are coated with a reflective deposit (14).

6. The method of any of claims 1 to 5, wherein the light-emitting diodes are nanowire light-emitting diodes (12).

7. The method of claim 6, wherein the nanowires are GaN nanowires.

8. The method of claim 7, wherein the nanowires are formed from a seed layer (10) deposited on the silicon layer (1).

9. The method of any of claims 1 to 8, wherein the filling of the openings is performed with a transparent material (21, 23) provided with phosphors in its portion close to the light-emitting diodes.

10. The method of any of claims 1 to 9, wherein the external surface of the filling material is shaped to have desired optical characteristics.

11. The method of any of claims 1 to 10, wherein the support (2, 3) of the SOI-type wafer comprises a handle (3) and an insulating layer (2) interposed between the handle and the silicon layer (1) and wherein, at step (e), the handle is totally removed.
